(19) Europäisches Patentamt
European Patent Office
Office européen des brevets

(11) **EP 2 075 355 B1**

(12) **EUROPEAN PATENT SPECIFICATION**

(45) Date of publication and mention
of the grant of the patent:
**16.05.2012 Bulletin 2012/20**

(51) Int Cl.:
***C30B 15/10*** *(2006.01)*  ***C30B 29/06*** *(2006.01)*

(21) Application number: **08020756.6**

(22) Date of filing: **28.11.2008**

(54) **Inner crystallization crucible and pulling method using the crucible**

Innerer Kristallisierungstiegel und Ziehverfahren unter Verwendung des Tiegels

Creuset de cristallisation interne et procédé d'étirement utilisant le creuset

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **28.12.2007 JP 2007339346**

(43) Date of publication of application:
**01.07.2009 Bulletin 2009/27**

(73) Proprietor: **Japan Super Quartz Corporation**
**Akita-shi,**
**Akita-ken**
**010-0065 (JP)**

(72) Inventors:
• **Kishi, Hiroshi**
**Akita-shi**
**Akita-ken (JP)**

• **Kanda, Minoru**
**Akita-shi**
**Akita-ken (JP)**

(74) Representative: **Gulde Hengelhaupt Ziebig & Schneider**
**Patentanwälte - Rechtsanwälte**
**Wallstrasse 58/59**
**10179 Berlin (DE)**

(56) References cited:
**JP-A- 11 228 291    JP-A- 2005 320 241**
**US-A- 6 136 092     US-A1- 2002 029 737**
**US-A1- 2006 236 916   US-B1- 6 652 934**

**Description**

TECHNICAL FIELD

The present invention relates to a vitreous silica crucible used for pulling single-crystal silicon, and in particular, to a vitreous silica crucible providing a high yield of single-crystal silicon, which has a high density of the generated brown rings in the inner surface of the crucible upon pulling, and a high strength of the crucible, and hardly causes peeling of brown rings, and to a pulling method using the crucible.

The present application claims priority benefit based on Japanese Patent Application No. 2007-339346, filed on December 28,2007, the content of which is incorporated herein by reference.

BACKGROUND ART OF THE INVENTION

Single-crystal silicon used as a semiconductor material is usually manufactured by a single crystallization method (Czochralski (CZ) method) by pulling up a single crystal silicon ingot from a molten silicon contained in a vitreous silica crucible. The vitreous silica crucible including the silicon melt is brought into contact with a silicon melt at a temperature higher than a silicon melting point, and accordingly, the inner surface of the crucible is reacted with a silicon melt to generate uncounted numbers of crystal nuclei on the glass surface. A number of the generated crystal nuclei are degenerated according to the dissolution rate of the glass. The remaining crystal nuclei grow on the surface of the glass and in a direction perpendicular to the surface to develop crystallized spots in the form of a ring as the pulling proceeds. The peripheries of these spots are brown in color, and thus are called brown rings.

The inner part of the brown ring is a layer having no cristobalite layer or having a very thin cristobalite layer, if any. As the operating time increases, the area of the brown ring expands. Further, the adjacent brown rings are fused to each other to maintain their growth. Also, the portion encircled by the brown ring is eroded causing an irregular elution surface to appear on the glass. If this elution surface appears on the glass, dislocation easily occurs on a single-crystal silicon, thereby interfering with the yield of the single crystal pulling.

Furthermore, the brown ring of the inner surface of the crucible is often peeled off (or exfoliated), and this peeled piece is incorporated into a silicon melt, causing deterioration of single crystallization. Thus, a vitreous silica crucible that inhibits generation of a brown ring to the maximum was developed. For example, JP-A No. 11-228291 describes a vitreous silica crucible in which by uniformly distributing the impurities which become the production nuclei of crystallized spots, at a lower concentration, the density of the crystallized spots produced in the inner surface of the crucible is controlled to 5 spots/cm$^2$ or less.

On the other hand, the brown ring on the inner surface of the crucible is related to vibration of the melt surface of the silicon melt. It has been pointed out that a small number of the brown rings make the vibration of the melt surface of the silicon melt easier. This vibration can be often found at an initial pulling step in the former part of the single crystal body upon formation of a shoulder by seeding. As a result, in some cases, a seeding operation required a certain period of time, or crystals were dislocated, and then became molten again causing so-called melt-back, or lowering the productivity. In order to solve this problem, JP-ANo. 2005-320241 proposes a vitreous silica crucible, in which many brown rings are generated on an inner surface part that is underneath the initial melt surface position at a certain distance.

However, although the inner surface of the crucible has a large number of the generated brown rings that inhibit the vibration of the melt surface of a silicon melt, the peeling of the brown ring lowers the yield of the single-crystal silicon. As a result, there is a need for a crucible in which generated brown rings hardly peel.

In US 2006/236916 A1 a vitreous silica crucible is disclosed wherein the concentration of OH groups rises from the outside to the inside with the highest OH group concentration in the transparent layer layer to be contacted with the silicon melt.

DETAILED DESCRIPTION OF THE INVENTION

The present invention has been made to solve the above-described problems in conventional vitreous silica crucibles, and is intended to control the concentration of OH groups on a thin surface layer of the inner layer of the crucible, and thus to lower a dissolution rate of the vitreous silica of the thin surface layer, whereby the crystal nuclei of the brown ring readily remain. Also, concurrently, the concentration of OH groups in the underlying layer of the thin surface layer is controlled so as to allow easy growth of the crystal nuclei. In addition, by this constitution, the present invention provides a vitreous silica crucible inhibiting the peeling of the brown ring.

The invention relates to a vitreous silica crucible which has solved the above-mentioned problems by employing the following constitutions, and to a pulling method using the vitreous silica crucible.

A vitreous silica crucible for pulling single-crystal silicon as defined in the claims is provided.

A method for pulling single-crystal silicon as defined in the claims is provided.

Since the concentration of OH groups in the surface glass layer with a thickness of 100 $\mu$m from the inner surface of the crucible is equal to or more than 30 ppm and equal to or less than 80 ppm in the vitreous silica crucible of the present invention, the dissolution rate of the surface glass layer is low. For this reason, the generated crystal nuclei grow into brown rings, thereby improving the strength of the crucible.

In the vitreous silica crucible of the present invention, specifically, since the brown ring moving in a thickness direction perpendicular to the inner surface of the crucible has an apparent growth rate of 1 $\mu$m/hr or more, the density of the generated brown rings is 2 rings/cm$^2$ or more, and preferably 5 rings/cm$^2$ or more, under a common pulling condition. As such, since the generation density of the brown rings is high, the strength of the crucible is enhanced.

Also, in the vitreous silica crucible of the present invention, since the concentration of OH groups in the glass layer of the underlying surface glass layer is equal to or more than 95 ppm and equal to or less than 170 ppm and crystallization easily occurs, the grown brown ring is difficult to be peeled off. Specifically, in the vitreous silica crucible of the present invention, the peeling rate of the brown ring (a percentage of the peeled area/the inner area of the brown ring) under a common pulling condition is preferably 10% or less, and for this reason, the brown ring is difficult to be peeled off. Accordingly, the yield of the single-crystal silicon is enhanced.

Furthermore, since the bubble content of the glass layer with a thickness of 1 mm from the inner surface of the crucible is preferably 0.1% or less in the vitreous silica crucible of the present invention, the number of the expanded bubbles is greatly reduced, and for this reason, the brown ring is more difficult to be peeled off.

BRIEF DESCRIPTION OF THE DRAWINGS

FIG. 1 is a vertical cross-sectional view illustrating an embodiment of the vitreous silica crucible for pulling single-crystal silicon according to the present invention.
FIG. 2 is a horizontal cross-sectional view illustrating a vitreous silica crucible manufacturing device.
FIG 3 is a vertical cross-sectional view illustrating a single-crystal silicon pulling step.
FIG. 4 is a flow chart illustrating a single-crystal silicon pulling step.

BEST MODE FOR CARRYING OUT THE INVENTION

(Vitreous Silica Crucible)

Hereinbelow, the embodiments of the present invention will be described in detail with reference to the drawings.

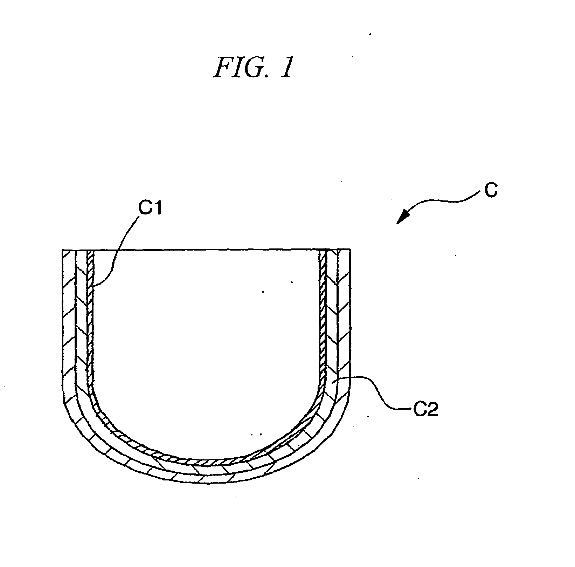

FIG. 1 is a cross-sectional view illustrating a first embodiment of the vitreous silica crucible for pulling single-crystal silicon according to the present invention.

A vitreous silica crucible C has a surface glass layer with a thickness of 100 $\mu$m from the inner surface of the crucible (hereinafter referred to as a first surface glass layer C1), and a glass layer with a thickness of 1 mm from the inner surface of the crucible (hereinafter referred to as a second surface glass layer C2, or the underlying glass layer) which is a portion at the lower side of the above layer.

The first surface glass layer C1 is a glass layer with a thickness of 100 $\mu$m from the inner surface of the crucible, and has a concentration of OH groups of equal to or more than 30ppm and equal to or less than 80ppm. The second surface glass layer C2 is a glass layer with a thickness of 1 mm from the inner surface of the crucible that is at the lower side of the first surface glass layer C1, and has a concentration of OH groups of equal to or more than 95 ppm and equal to or less than 170 ppm.

The vitreous silica crucible is formed by melting vitreous silica powder (raw powder) in a crucible shape for vitrification. Although since the vitreous silica powder as a raw material contains a trace amount of OH groups together with $SiO_2$ as a main component, the glass layer of the crucible contains more or less OH groups. If this concentration of OH groups is high, the viscosity of the glass is lowered, and OH groups are incorporated into the chains of the glass structure. Accordingly, the glass structure is easily cleaved, making the crystallization easier. On the other hand, if the concentration of OH groups in the glass layer is low, the viscosity of the glass is maintained, whereby the glass is hardly dissolved. The present invention employs these two properties.

Particularly, in a synthetic fused silica powder obtained by a sol-gel method, silanol produced by alkoxide hydrolysis remains usually in an amount of 50 ppm to a few hundred ppm. As such, the silanol-containing synthetic fused silica powder is used to prepare a surface glass layer of the vitreous silica crucible.

The vitreous silica crucible C used for pulling single-crystal silicon undergoes melting-damage by the reaction of the silicon melt with the crucible inner layer to be in contact therewith. Particularly, under a reduced atmospheric pressure, the amount of oxygen which generates from the inner wall of the crucible, dissolves into the molten silicon as a solid solution, and diffuses into the atmospheric gas from the molten silicon, is increased in accordance with the

following formula:

$$SiO_2 \rightarrow Si + O_2 \qquad (1)$$

In the vitreous silica crucible C of the present invention, the concentration of OH groups in the first surface glass layer C1 with a thickness of 100 $\mu$m from the inner surface of the crucible is equal to or more than 30ppm and equal to or less than 80ppm. Accordingly, the dissolution rate of the first surface glass layer C1 is low, and the generated crystal nuclei in the surface glass layer are hardly lost until the generated crystal nuclei sufficiently grow in a direction perpendicular to the surface. Thus, the density of the generated brown rings in the inner surface of the crucible upon pulling the single-crystal silicon is increased.

In the vitreous silica crucible C of the present invention, a second surface glass layer C2 with a thickness of 1 mm from the inner surface of the crucible (which is hereinafter referred to as a underlying glass layer) which is a portion at the lower portion of the surface glass layer containing crystal nuclei has a concentration of OH groups of equal to or more than 95 ppm and equal to or less than 170 ppm. As such, the second surface glass layer C2 has a higher concentration of OH groups than the first surface glass layer C1. Therefore, this underlying glass layer (a second surface glass layer C2) is more easily crystallized than the first surface glass layer C1. As a result, the grown crystal nuclei are not dissolved, and are increased in size to form a brown ring, and accordingly, the area of the brown ring in the inner surface of the crucible is increased, thereby improving the strength of the crucible. Also, since the brown ring is hardly dissolved and peeled, the yield of the single-crystal silicon is enhanced.

The first surface glass layer C1 has a concentration of OH groups of equal to or more than 30 ppm and equal to or less than 80 ppm, and particularly preferably equal to or more than 40 and equal to or less 70 ppm. If the first surface glass layer C1 has a concentration of OH groups of more than 90 ppm, the fusion rate of the first surface glass layer C1 is high, and it is possible that the generated crystal nuclei are lost by melting before they grow. On the other hand, if the concentration of OH groups is less than 1 ppm, there is a possibility that the density of brown rings per unit area will decrease. The reason of this can be presumed as follows. For the generation of brown rings, Si layers of oxygen rich is necessary to exist in the interface between $SiO_2$ and Si. Therefore, if the concentration of OH groups in the vitreous silica is low, the fusion rate of the vitreous silica decreases, the oxygen-rich Si layer cannot be generated on the surface of the vitreous silica. The density of brown rings thereby decreases.

The second surface glass layer C2 has a concentration of OH groups of equal to or more than 95 ppm and equal to or less 170 ppm, and particularly preferably equal to or more than 100 ppm and equal to or less 150ppm or less. If the second surface glass layer C2 has a concentration of OH groups of less than 90 ppm, a preferable crystallization rate of the second surface glass layer C2 cannot be obtained. On the other hand, if the second surface glass layer C2 has a concentration of OH groups of more than 200 ppm, there is a possibility that the crucible deforms due to a decrease of the viscosity (hardness) of the vitreous silica supporting brown rings.

As for the method for measuring the concentration of OH groups, an infrared spectrophotometry (FT-IR) method can be used. Specifically, the concentration of OH groups can be measured by obtaining an absorption spectrum at a wave length of 3672 nm absorbed by OH groups using a conventional FT-IR apparatus.

The first surface glass layer C1 is a glass layer with a thickness of 100 $\mu$m from the inner surface of the crucible. The second the surface glass layer C2 is a glass layer with a thickness of 1 mm from the inner surface of the crucible that is a portion at the lower side of the first surface glass layer C1.

Furthermore, although any thickness of the first surface glass layer C1 and the second surface glass layer C2 at an equivalent ratio to the above thickness can be used, other thicknesses may be applied.

Also, in FIG. 1, the thicknesses of the surface glass layer C1 and the second surface glass layer C2 are uniformly distributed across the vitreous silica crucible. However, a thick constitution may be applied around the lower portion of the vitreous silica crucible since it has a long contact time with the silicon melt.

In the vitreous silica crucible of the present invention, specifically, for example, the brown ring moving in a thickness direction perpendicular to the inner surface of the crucible has an apparent growth rate of 1 $\mu$m/hr or more. Thus, under common pulling conditions (for example, a temperature of equal to or more than 1450°C and equal to or less than 15550°C, and a pulling pressure of 20 torr or more, of a silicon melt product), the density of the generated brown rings is 2 rings/cm$^2$ or more, and preferably 5 rings/cm$^2$ or more. Under the same conditions, a conventional common vitreous silica crucible has a brown ring density of about 1 ring/cm$^2$. That is, the density of the brown ring in the vitreous silica crucible having a preferable shape according to the present invention is significantly higher, and thus it has an effect of improving the strength of the crucible.

Furthermore, the density of the brown ring preferably has an upper limit of 10 rings/cm$^2$ or less.

In the vitreous silica crucible of the present invention, the brown ring moving in a thickness direction perpendicular to the inner surface of the crucible has an apparent growth rate of 1 $\mu$m/hr or more under the above-described common pulling conditions. The apparent growth rate of the brown ring is defined by equation (2).

$$\text{Apparent growth rate } (\mu m/hr) = \text{Growth rate of brown ring } (\mu m/hr) - \text{Dissolution}$$

$$\text{rate of brown ring } (\mu m/hr) \qquad (2)$$

Furthermore, the growth rate of the brown ring and the dissolution rate of the brown ring can be determined by microscopy of the inner surface of the crucible at each step of the pulling, or by other methods.

Also, the brown ring more preferably has an apparent growth rate of 2 $\mu m/hr$ or more, and particularly preferably 4 $\mu m/br$ or more. On the other hand, the upper limit of the apparent growth rate of the brown ring is preferably 20 $\mu m/hr$ in terms of the preparation of single-crystal silicon.

Since the apparent growth rate of the brown ring is 1 $\mu m/hr$ or more in the vitreous silica crucible of the present invention, as described above, the brown ring is difficult to be peeled off. Accordingly, the peeling rate of the brown ring (a percentage of the peeled area/the inner area of the brown ring) is 10% or less under the above-described common pulling conditions. As the peeling rate lowers, the yield of the single-crystal silicon is further enhanced.

In the vitreous silica crucible of the present invention, the bubble content in the glass layer with a thickness of 1 mm from the inner surface of the crucible is 0.1% or less. The vitreous silica crucible undergoes melting-damage in the glass layer with a thickness of 1 mm from the inner surface of the crucible, by its reaction with the silicon melt upon pulling single-crystal silicon. With a high amount of the bubbles contained in this part, the brown ring around the bubbles is easily peeled off owing to expansion of the bubbles. In the vitreous silica crucible of the present invention, the bubble content in this portion is low and the number of the expanded bubbles is inhibited, and thus the brown ring is more difficult to be peeled off.

Furthermore, % in the bubble content represents % by volume.

(Method for preparing Vitreous Silica Crucible)

Examples of the raw powder (vitreous silica powder) include synthetic fused silica powder and natural quartz powder.

Here, the synthetic fused silica powder refers to powder consisting of synthetic fused silica, and the synthetic fused silica refers to a chemically synthesized or prepared raw material, in which the synthetic fused silica powder is amorphous. Since the synthetic fused silica raw material is gas or liquid, it can be easily purified, and the synthetic fused silica powder can have a higher purity than the natural quartz powder. Examples of the synthetic fused silica raw materials include those derived from gas raw materials such as carbon tetrachloride and those derived from liquid raw materials such as silicon alkoxide. In the synthetic fused silica powder, it is possible that all the impurities are at 0.1 ppm or less.

In the vitreous silica crucible of the present invention, the first surface glass layer C1 and the second surface glass layer C2 can be made of those containing a trace amount of OH groups together with $SiO_2$ as a main component among the synthetic fused silica powder. In particular, among the synthetic fused silica powder, those obtained by a sol-gel method, and containing silanol produced by alkoxide hydrolysis usually in an amount of 50 ppm to 100 ppm, are preferable. In the synthetic fused silica containing carbon tetrachloride as a raw material, the residual amount of silanol can be controlled over a wide range of equal to or more than 0 ppm and equal to or less than 1000 ppm, but usually chlorine is contained in an amount of about 100 ppm or more. If alkoxides are used as a raw material, synthetic fused silica containing no chlorine can be easily prepared.

Although the present invention uses vitreous silica powder as raw powder, as used herein, the "vitreous silica powder" can include, as long as it satisfies the above conditions, crystal, silica sand, and the like, including silicon dioxide (silica), not limited to vitreous silica, as well as powder of well-known materials as raw materials for a vitreous silica crucible.

In the vitreous silica crucible of the present invention, it is preferable that a synthetic fused silica having a low content of the silanol groups be used in the first surface glass layer C1. On the other hand, it is preferable that a synthetic fused silica having a higher concentration of OH groups in the second surface glass layer C2 as compared in the first surface glass layer C1 be used in the second surface glass layer C2. Specifically, it is preferable that a synthetic fused silica having a content of silanol groups of equal to or more than 10 ppm and equal to or less than 120ppm be used in the first surface glass layer C1. It is preferable that a synthetic fused silica having a content of silanol groups of equal to or more than 80 ppm and equal to or less than 300 ppm or less be used in the second surface glass layer C2.

Furthermore, in the first surface glass layer C1 and the second surface glass layer C2, it is desirable that a fmal concentration of OH groups be a desired value, and the synthetic fused silica to be used is not limited to those described above.

Furthermore, from the inner surface of the vitreous silica crucible, the concentrations of OH groups in the first surface glass layer C1 and the second surface glass layer C2 may be adjusted by varying the temperature gradient toward the outside upon heating. More silanol is removed by further heating the synthetic fused silica powder, thereby lowering the concentration of OH groups.

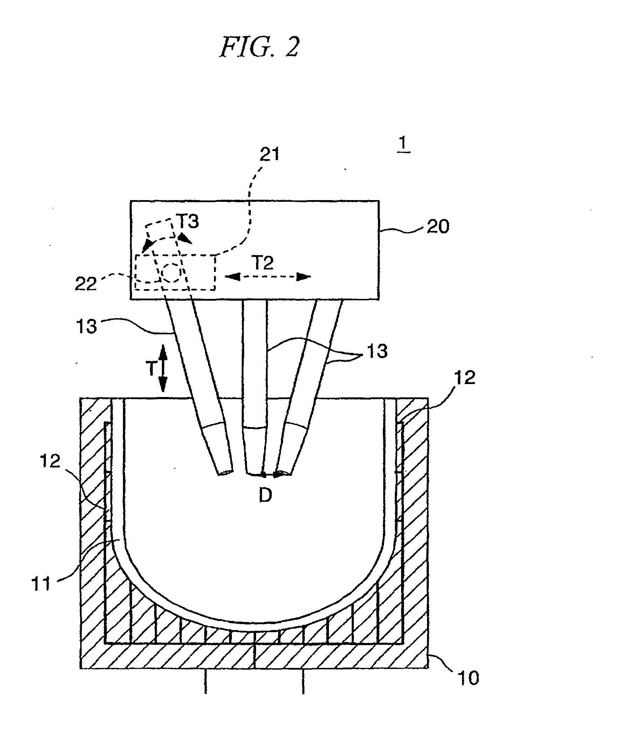

In the method for preparing the vitreous silica crucible of the present invention, a crucible manufacturing device 1 having a rotary mold 10 for performing vacuum pulling is used, as shown in FIG. 2

The vitreous silica crucible manufacturing device 1 is roughly constituted of a mold 10 which has a melting space in the inner part for melting a vitreous silica powder and forming a vitreous silica crucible; a driving mechanism which rotates the mold 10 around the axis; and a plurality of carbon electrodes 13 which acts as an arc discharge means for heating the inner side of the mold 10.

The mold 10 is formed of, for example, carbon, and a number of pressure-reducing passages 12 which are open to the surface of the inner part of the mold 10 are formed inside. The pressure-reducing passage 12 is connected to a pressure-reducing mechanism, which thus allows suction of air from the inner surface of the mold 10 via the pressure-reducing passage 12 at the time of rotating the mold 10. The atmospheric pressure around the mold 10 can be subjected to depressurization or pressurization by an atmospheric pressure control device (not shown).

A plurality of electrodes 13 is provided as the arc discharge means at the upper side of the mold 10 in the vitreous silica crucible manufacturing device 1. In the example shown in the figure, the electrode 13 is formed of a combination of three electrodes. The electrodes 13 are each fixed to a support 20 at the upper part of a furnace, and the support 20 is provided with a means (omitted in the figure) to vertically move the carbon electrode 13.

The support 20 is provided with a supporting part 21 that supports the carbon electrode 13 while allowing setting of the distance D between the electrodes, a horizontally transferring means that allows the supporting part 21 to move in a horizontal direction T2, and a vertically transferring means that allows the plurality of supporting parts 21 and the respective horizontally transferring means to move integrally in a vertical direction T. The supporting part 21 supports by allowing the carbon electrode 13 to move around an angle setting axis 22, and is provided with a rotation means that controls the rotation angle of the angle setting axis 22. In order to adjust the setting position of the carbon electrodes 13, the angle direction T3 of the carbon electrode 13 is controlled by the rotation means, as well as the horizontal position of the supporting part 21 being controlled by the horizontally transferring means and the height of the supporting part 21 also being controlled by the vertical transferring means.

Furthermore, the supporting part 21 and the like are shown at only the left end of the carbon electrode 13 in the figure, but other electrodes are also supported by the same constitution, and the height of each carbon electrode 13 can be controlled individually.

After deposition of the vitreous silica powder 11, an arc electrode 13 provided on the upper side of the mold space is used to melt the vitreous silica powder by heating to achieve vitrification, vacuum pulling is performed upon melting by a depressurization mechanism via a pressure-reducing passage 12, and the bubbles of the inner layer are sucked to form a transparent glass layer. After vitrification, it is cooled, and then taken out of the mold to obtain a vitreous silica crucible C.

At this time, in order to prepare the vitreous silica crucible of the present invention, it is preferable that the vitreous silica powder used in the second surface glass layer C2 be laminated to approximately equal to or more than 0.5 mm and equal to or less than 5 mm. Also, it is preferable that the vitreous silica powder used in the first surface glass layer C2 be laminated to approximately equal to or more than 1 mm and equal to or less than 2.5mm.

(Method for preparing single-crystal silicon)

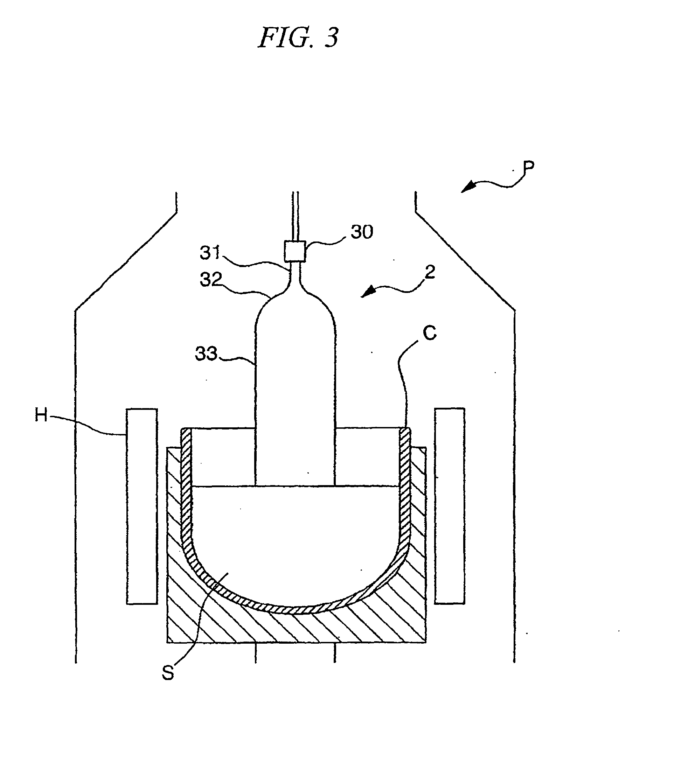

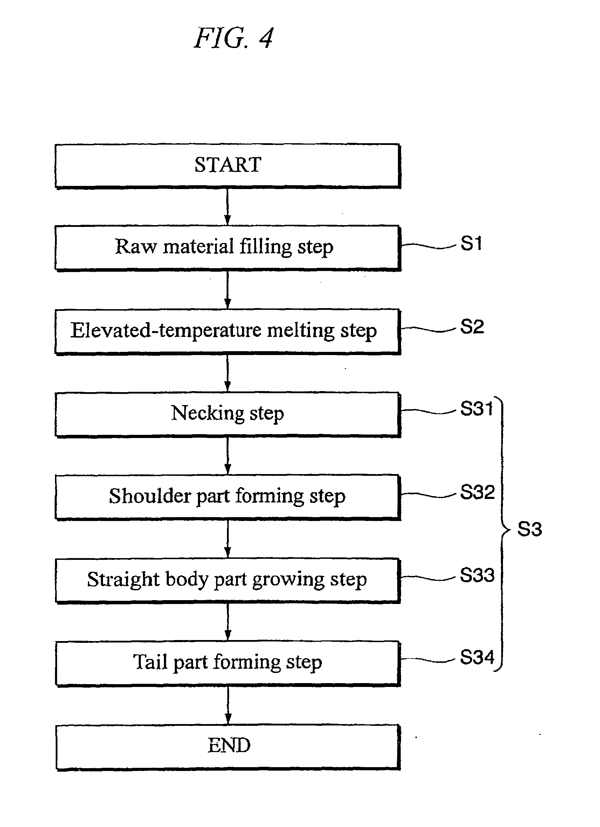

FIG. 4 is a flow chart illustrating the single-crystal silicon pulling method using the vitreous silica crucible of the present embodiment. FIG. 3 is a front cross-sectional view illustrating the pulling of single-crystal silicon using the vitreous silica crucible in the present embodiment.

The pulling of single-crystal silicon using the vitreous silica crucible C in the present embodiment is, for example, in accordance with the CZ (Czochralski) method.

The single-crystal silicon pulling method has a raw material filling step S1, an elevated-temperature melting step S2; a necking step S31, a shoulder part forming step S32, a straight body part growing step S33, and a tail part forming step S34 for removing single crystal from the melt by diameter shrinkage in a pulling step S3, as shown in FIG 4.

In the raw material filling step S1, the vitreous silica crucible C is filled with the multi-crystal silicon mass, as a raw material.

In the elevated-temperature melting step S2, the vitreous silica crucible C filled with the raw material is disposed in the single crystal-pulling furnace P, as shown in FIG. 3. Thereafter, the pressure, the atmosphere, the temperature, and the time are adjusted to form a silicon melt S. The atmospheric state in the single crystal-pulling furnace is such as, for example, a melting pressure of 1.33 to 26.66 kPa (10 torr to 200 torr). For the atmosphere, an inert gas atmosphere, such as an argon gas atmosphere, and the like is used. Further, by a heating means, H, as shown in FIG. 3, the temperature is elevated from room temperature to a pulling temperature of equal to or more than 1400°C and equal to or less than 1550°C for a time of equal to or more than 5 hours and equal to or less than 25 hours. This pulling temperature is maintained for 10 hours to melt a multi-crystal raw material silicon mass, thereby forming a silicon melt S.

Thereafter, in the pulling step S3, under the same pulling atmospheric conditions as the melting step atmospheric conditions, or predetermined pulling atmospheric conditions, a seed crystal (single-crystal silicon) 30 is immersed in a silicon melt S as shown in FIG. 3, and the seed crystal is slowly pulled up while rotating the crucible, thereby allowing the single-crystal silicon 2 to grow, with the seed crystal 30 being a nucleus.

At this time, with the use of the vitreous silica crucible of the present invention, the pressure may be a normal pressure of equal to or more than 500 torr and equal to or less than 760 torr, a slightly reduced pressure of equal to or more than 300 torr and equal to or less than 500 torr, or a reduced pressure of equal to or more than 20 torr and equal to or less than 300 torr.

Usually, under the reduced pressure state of equal to or more than 20 torr and equal to or less than 300 torr, a layer containing no bubble is required to be disposed with a thickness of about 5 mm from the inner side. However, by the constitution of the present invention, even when the layer having a bubble content of 0.1% or less is disposed with a thickness of 1 mm, the density of the brown ring can be increased, and it can also be difficult to peel the generated brown ring.

In a necking step S31 in the pulling step S3, dislocation by thermal impact is eliminated from the crystal surface to form a necking part 31. Thereafter, in the shoulder part forming step S32, the shoulder part 32 is formed by diameter expansion; in the straight body part growing step S33, a single-crystal silicon 2 having a straight body part 33 taking a silicon wafer is grown; and in the tail part forming step S34, the single crystal is taken out from the melt by diameter shrinkage.

Furthermore, in the vitreous silica crucible of the present invention, the gradient of the concentration of OH groups may increase in the thickness direction from the inner surface of the vitreous silica crucible to the outer surface of the vitreous silica crucible. The gradient of the concentration of OH groups (ppm/mm) is preferably equal to or more than 15 and equal to or less than 400, more preferably equal to or more than 30 and equal to or less than 300, more preferably equal to or more than 60 and equal to or less than 100 or less.

As described above, in the vitreous silica crucible of the present invention, the density of the generated brown rings in the inner surface of the crucible is high upon pulling, and the generated brown ring is difficult to be peeled off. Accordingly, by using the vitreous silica crucible of the present invention as a crucible for pulling single-crystal silicon, the yield of single crystallization can be enhanced.

EXAMPLES

(Examples 1 to 2 and Comparative Examples 1 to 3)

A vitreous silica crucible (opening diameter 32 inches) having a concentration of OH groups and a bubble content as shown in Table 1 was prepared, and the pulling of single-crystal silicon was carried out using the vitreous silica crucible. These results are shown in Table 1.

As can be seen from Table 1, in Comparative Example 1, the inner surface of the crucible has a low concentration of OH groups in the first surface glass layer, and a high density of the brown ring. However, since the underlying glass layer (the second surface glass layer) has a low concentration of OH groups, the apparent growth rate of the brown ring is low. Accordingly, the peeling rate of the brown ring is high. Also, in Comparative Examples 2 and 3, the first surface glass layer has a high OH concentration, and the dissolution rate of glass is high. Accordingly, the density of the brown ring is low. Furthermore, since the apparent growth rate of the brown ring is low, the peeling rate of the brown ring is high.

On the other hand, in Examples 1 to 2 using the crucible of the present invention, the density of the brown ring is high, and the strength of the crucible is high. As a result, the crucible is not deformed. Also, the bubble content in the thickness portion that has undergone melt-damage is low, and the apparent growth rate of the brown ring is high. As a result, the peeling rate of the brown ring is low. Thus, the yield of the single crystallization is high.

The concentration of OH groups in Table 1 is a value measured by a infrared spectrophotometry (FT-IR) in the first surface glass layer and the second surface glass layer.

The bubble content (% by volume) in Table 1 was measured by taking a photographic image of the bubbles by an optical means for a portion with a thickness of 1 mm from the vitreous silica crucible inner layer, and then subjecting it to imaging.

The peeling rate in Table 1 was determined by measuring the peeled area and the inner area of the brown rings by taking photographs of the brown rings by a digital camera, and representing it as a percentage of the peeled area/the inner area of the brown ring.

The apparent growth rate of brown rings in Table 1 was computed by the following equation (3):

$$[\text{Apparent growth rate } (\mu m/hr)] = [\text{Thickness of brown ring } (\mu m)] / [\text{Residence}$$

$$\text{time in the molten silicon } (hr)] \quad \cdots (3)$$

After manufacturing a single-crystal silicon ($\varphi$300mm) using the vitreous silica crucibles (opening diameter: 32 inch) for 200 hours, the brown ring density in Table 1 was measured by image-processing of photograph of the inner surface of the crucibles taken by a digital camera. If neighboring brown rings are integrated to form one greater brown ring, in particular, on the inner bottom surface of the crucible which contacts the remaining molten silicon after pulling-up the single crystal silicon, the number of brown rings can be measured as follows. First, the average area per one brown ring is calculated by measuring diameters of independent (not integrated) brown rings in the same target region to be observed. Next, the area of each of the integrated brown rings is measured, and the number of brown rings included in the integrated brown ring is calculated by dividing the area of each of the integrated brown rings by the average area per one brown ring.

The deformation of crucible in Table 1 refers to a state of a vitreous silica crucible after preparation of single-crystal silicon for 200 hours using a vitreous silica crucible (opening diameter: 32 inch). A case where deformation of a vitreous silica crucible is observed with the naked eye is evaluated as "Yes", whereas a case where deformation of a vitreous silica crucible is not observed with the naked eye is evaluated as "No".

The yield in Table 1 is a percentage of a mass of a straight body part capable of taking out a wafer of single-crystal silicon having neither crystal deformation nor impurities/ the total mass of polysilicon introduced into a crucible. If this single crystallization rate is changed by 1% by mass, the wafer capable of being taken is changed by about 20 sheets.

[Table 1]

TABLE 1

| | Concentration of OH groups | | Content of bubbles (%) | Peeling rate (%) | Apparent growth rate ($\mu$m/h) | BR density (rings/cm$^2$) | Deformation of crucible | Yield (%) |
|---|---|---|---|---|---|---|---|---|
| | Surface glass layer | Underlying glass layer | | | | | | |
| Example 1 | 75 | 110 | 0.03 | 0 | 3 | 6 | No | 92 |
| Example 2 | 71 | 150 | 0.08 | 5 | 10 | 5 | No | 89 |
| Comparative Example 1 | 73 | 76 | 0.04 | 24 | 0.5 | 6 | No | 61 |
| Comparative Example 2 | 110 | 110 | 0.04 | 36 | 2 | 1 | Yes | 45 |
| Comparative Example 3 | 120 | 74 | 0.05 | 29 | 0.3 | 1 | Yes | 44 |

In Table 1, the surface glass layer is a portion with a thickness of 100 $\mu$m from the inner surface of the crucible surface. The underlying glass layer is at a lower side of the surface glass layer, which is a portion with a thickness of 1 mm from the inner surface of the vitreous silica crucible surface. "BR" denotes a brown ring.

**Claims**

1. A vitreous silica crucible for pulling single-crystal silicon, comprising:

a surface glass layer having a thickness of 100 $\mu$m from an inner surface of the crucible; and an underlying glass layer provided below the surface glass layer in a thickness direction of the crucible and extending to a depth of 1 mm from the inner surface of the crucible, wherein the concentration of OH groups in the surface glass layer is equal to or more than 30 ppm and equal to or less than 80 ppm, and the concentration of OH groups in the underlying glass layer is equal to or more than 95 ppm and equal to or less than 170 ppm, and wherein the bubble content in the glass layer is 0.1 % or less.

2. The vitreous silica crucible according to claim 1, wherein the crucible has a property that, when the crucible is used for pulling a single crystal silicon at a temperature of equal to or more than 1450°C and equal to or less than 1550°C and a pulling pressure of 20 torr or more, the density of brown rings to be generated on the inner surface of the crucible is 2 rings/cm$^2$ or more.

3. The vitreous silica crucible according to claim 2, wherein the density of brown rings to be generated on the inner surface of the crucible is 5 rings/cm$^2$ or more.

4. The vitreous silica crucible according to claim 1, wherein the crucible has a property that, when the crucible is used for pulling a single crystal silicon at a temperature of equal to or more than 1450°C and equal to or less than 1550°C and a pulling pressure of 20 torr or more, an apparent growth rate of the brown ring ([apparent growth rate] = [growth rate of brown ring] - [dissolution rate of brown ring]) to be formed in a thickness direction perpendicular to the inner surface of the crucible is 1 $\mu$m/hr or more.

5. The vitreous silica crucible according to claim 1, wherein the crucible has a property that, in pulling the silicon melt product at a temperature of 1450°C or more and 1550°C or less and a pulling pressure of 20 torr or more, the brown ring peeling rate ([peeled area]/[inner area of brown ring]) is 10% or less.

6. A method for pulling single-crystal silicon, using the vitreous silica crucible according to claim 1.

**Patentansprüche**

1. Quarzglastiegel zum Ziehen von Einkristall-Silicium, umfassend:

   eine Oberflächenglasschicht mit einer Dicke von 100 $\mu$m von der Innenfläche des Tiegels und eine darunter liegende Glasschicht, die unter der Oberflächenglasschicht in Richtung der Dicke des Tiegels vorgesehen ist und sich in eine Tiefe von 1 mm von der Innenfläche des Tiegels erstreckt, wobei die Konzentration der OH-Gruppen in der Oberflächenglasschicht gleich oder größer als 30 ppm und gleich oder kleiner als 80 ppm ist und die Konzentration der OH-Gruppen in der darunter liegenden Glasschicht gleich oder größer als 95 ppm und gleich oder kleiner als 170 ppm ist und der Blasengehalt in der Glasschicht 0,1% oder weniger ist.

2. Quarzglastiegel nach Anspruch 1, wobei der Tiegel die Eigenschaft aufweist, dass bei Verwendung des Tiegels zum Ziehen von Einkristall-Silicium bei einer Temperatur gleich oder größer als 1450°C und gleich oder kleiner als 1550°C und einem Ziehdruck von 20 Torr oder mehr die Dichte der an der Innenfläche des Tiegels erzeugten braunen Ringe 2 Ringe/cm$^2$ oder mehr beträgt.

3. Quarzglastiegel nach Anspruch 2, wobei die Dichte der an der Innenfläche des Tiegels erzeugten braunen Ringe 5 Ringe/cm$^2$ oder mehr beträgt.

4. Quarzglastiegel nach Anspruch 1, wobei der Tiegel die Eigenschaft aufweist, dass bei Verwendung des Tiegels zum Ziehen von Einkristall-Silicium bei einer Temperatur gleich oder größer als 1450°C und gleich oder kleiner als 1550°C und einem Ziehdruck von 20 Torr oder mehr die Nettowachstumsgeschwindigkeit des in Richtung der Dicke senkrecht zur Innenfläche des Tiegels gebildeten braunen Rings ([Nettowachstumsgeschwindigkeit] = [Wachstumsgeschwindigkeit des braunen Rings] - [Auflösungsgeschwindigkeit des braunen Rings]) 1 $\mu$m/h oder mehr beträgt.

5. Quarzglastiegel nach Anspruch 1, wobei der Tiegel die Eigenschaft aufweist, dass die Abziehrate der braunen Ringe ([abgezogene Fläche]/[Innenfläche des braunen Rings]) beim Ziehen des Produkts der Silicium-Schmelze bei einer Temperatur von 1450°C oder mehr und 1550°C oder weniger und einem Ziehdruck von 20 Torr oder mehr 10% oder weniger beträgt.

6. Verfahren zum Ziehen von Einkristall-Silicium unter Verwendung des Quarzglastiegels nach Anspruch 1.

**Revendications**

1. Creuset en verre de silice pour tirer du silicium monocristallin, comprenant : une couche de verre de surface ayant une épaisseur de 100 $\mu$m à partir d'une surface intérieure du creuset, et une couche de verre sous-jacente prévue sous la couche de surface de verre dans le sens de l'épaisseur du creuset et s'étendant à une profondeur de 1 mm à partir de la surface intérieure du creuset, dans lequel la concentration des groupes OH dans la couche de verre de surface est égale ou supérieure à 30 ppm et égale ou inférieure à 80 ppm, et la concentration des groupes OH dans la couche de verre sous-jacente est égale ou supérieure à 95 ppm et égale ou inférieure à 170 ppm, et dans lequel la teneur en bulles dans la couche de verre est de 0,1 % ou moins.

2. Creuset en verre de silice selon la revendication 1, dans lequel le creuset a une propriété qui fait que, lorsque le creuset est utilisé pour tirer du silicium monocristallin à une température égale ou supérieure à 1450 °C et égale ou inférieure à 1550 °C et à une pression de tirage de 20 torrs ou plus, la densité des anneaux bruns à générer sur la surface intérieure du creuset est de 2 anneaux/cm$^2$ ou plus.

3. Creuset en verre de silice selon la revendication 2, dans lequel la densité des anneaux bruns à générer sur la surface intérieure du creuset est de 5 anneaux/cm$^2$ ou plus.

4. Creuset en verre de silice selon la revendication 1, dans lequel le creuset a une propriété qui fait que, lorsque le creuset est utilisé pour tirer du silicium monocristallin à une température égale ou supérieure à 1450 °C et égale ou inférieure à 1550 °C et à une pression de tirage de 20 torrs ou plus, une vitesse de croissance apparente de l'anneau brun ([vitesse de croissance apparente] = [vitesse de croissance de l'anneau brun] - [vitesse de dissolution de l'anneau brun]) à former dans un sens d'épaisseur perpendiculaire à la surface intérieure du creuset est de 1 μm/h ou plus.

5. Creuset en verre de silice selon la revendication 1, dans lequel le creuset a une propriété qui fait que, en tirant le produit fondu de silicium à une température égale de 1450 °C ou supérieure et de 1550 °C ou inférieure et à une pression de tirage de 20 torrs ou plus, la vitesse d'écaillage de l'anneau brun ([surface écaillée]/[surface intérieure de l'anneau brun]) est de 10 % ou moins.

6. Procédé pour tirer du silicium monocristallin, utilisant le creuset en verre de silice selon la revendication 1.

*FIG. 1*

# FIG. 2

*FIG. 3*

## FIG. 4

```
        ┌─────────────────────────────┐
        │            START            │
        └─────────────────────────────┘
                      │
                      ▼
        ┌─────────────────────────────┐
        │   Raw material filling step  │────── S1
        └─────────────────────────────┘
                      │
                      ▼
        ┌─────────────────────────────┐
        │ Elevated-temperature melting step │────── S2
        └─────────────────────────────┘
                      │
                      ▼
        ┌─────────────────────────────┐
        │         Necking step         │────── S31 ⎤
        └─────────────────────────────┘           │
                      │                            │
                      ▼                            │
        ┌─────────────────────────────┐           │
        │    Shoulder part forming step │────── S32 │
        └─────────────────────────────┘           ⎬ S3
                      │                            │
                      ▼                            │
        ┌─────────────────────────────┐           │
        │  Straight body part growing step │────── S33 │
        └─────────────────────────────┘           │
                      │                            │
                      ▼                            │
        ┌─────────────────────────────┐           │
        │     Tail part forming step   │────── S34 ⎦
        └─────────────────────────────┘
                      │
                      ▼
        ┌─────────────────────────────┐
        │             END             │
        └─────────────────────────────┘
```

**EP 2 075 355 B1**

**REFERENCES CITED IN THE DESCRIPTION**

**Patent documents cited in the description**

- JP 2007339346 A
- JP 11228291 A
- JP 2005320241 A
- US 2006236916 A1